# FASCICULE DE BREVET EUROPEEN

(11) **EP 0 959 362 B1**
(45) Date de publication et mention de la délivrance du brevet: **23.02.2005**
(21) Numéro de dépôt: 99401190.6
(22) Date de dépôt: 17.05.1999
(51) Int. Cl.: G01R 31/28, G01D 5/20, G01D 3/08

(54) **Dispositif de mesure d'une grandeur physique liée à la rotation d'un organe**
Vorrichtung zur Messung einer mit der Rotation eines Organs zusammenhängenden physikalischen Grösse
Device for measuring a physical value related to the rotation of a body

(30) Priorité: 18.05.1998 FR 9806257; 09.06.1998 FR 9807246
(43) Date de publication de la demande: 24.11.1999
(73) Titulaire: Alstom France SA, 75116 Paris (FR)
(72) Inventeur: Auge de Fleury, Bernard, 93160 Noisy le Grand (FR); Zliechovec, Jean Yves, 95270 Seugy (FR); Bouttemy, Jean-Claude, 92130 Issy les Moulineaux (FR)
(74) Mandataire: Moncheny, Michel

(56) Documents cités:
- DE-A- 3 311 781
- DE-A- 3 505 765
- DE-A- 4 313 753
- US-A- 5 289 120
- PATENT ABSTRACTS OF JAPAN vol. 013, no. 450 (E-830), 11 octobre 1989 (1989-10-11) & JP 01 175140 A (MAKOME KENKYUSHO:KK), 11 juillet 1989 (1989-07-11)

## Description

La présente invention concerne un dispositif de mesure d'une grandeur physique liée à la rotation d'un organe et des procédés de contrôle de ce dispositif.

Elle s'applique en particulier à la mesure d'une grandeur physique liée à la rotation d'un essieu de bogie de véhicule ferroviaire.

On connaît déjà dans l'état de la technique un dispositif de mesure d'une grandeur physique liée à la rotation d'un organe comprenant un disque métallique, solidaire de l'organe rotatif, muni d'au moins un ajour formant repère.

Dans le cas d'un bogie de véhicule ferroviaire, le disque est solidaire d'un essieu (organe rotatif).

De façon classique, le dispositif de mesure fournit une grandeur physique liée au déplacement angulaire du disque qui permet de déduire notamment la distance parcourue par le véhicule ferroviaire ou bien la vitesse de ce véhicule.

Habituellement, le dispositif de mesure comporte un ensemble de détection optique et se présente sous la forme d'un module pré-assemblé destiné à être monté sur une extrémité libre d'un essieu de bogie. L'ensemble de détection optique et le disque sont protégés contre les poussières et salissures par des moyens d'étanchéité appropriés. Un tel module pré-assemblé peut avantageusement être agencé sur un bogie sans démontage de ce dernier.

Dans certain cas, le montage du module pré-assemblé sur l'extrémité libre d'un essieu de bogie est interdit ou impossible. Or, il est difficile d'adapter un tel module pour permettre son agencement sur une autre partie de l'essieu, ceci pour des raisons notamment de montage peu aisé, d'encombrement et/ou de protection contre l'eau, les poussières et salissures susceptibles d'entraver le bon fonctionnement de l'ensemble de détection optique.

L'invention a notamment pour but de proposer un dispositif permettant une mesure fiable d'une grandeur physique liée à la rotation d'un essieu de bogie, ce dispositif de mesure étant de plus facile à agencer sur le bogie.

DE 43 13 753 décrit un dispositif conforme au préambule de la revendication 1.

A cet effet, l'invention a pour objet un dispositif de mesure du type précité, caractérisé en ce qu'il comprend un ensemble fixe de détection de ce repère comprenant au moins un détecteur magnétique de proximité et des moyens de contrôle du bon fonctionnement de ce détecteur, agencés à l'extérieur du détecteur magnétique, sans contact ou raccordement électrique avec ce dernier.

Suivant d'autres caractéristiques de ce dispositif de mesure :
- les moyens de contrôle comprennent au moins une spire conductrice entourant une extrémité active du détecteur, raccordée à des moyens de modification de son état par mise en court-circuit ou par alimentation en courant de cette spire ;
- les moyens de contrôle comprennent une bobine conductrice constituée de plusieurs spires entourant une extrémité active du détecteur, raccordée à des moyens de modification de son état par mise en court-circuit ou par alimentation en courant de cette bobine ;
- le détecteur magnétique est un détecteur inductif de proximité ;
- le disque comprend n ajours répartis régulièrement sur un cercle centré sur son axe et l'ensemble de détection comprend p détecteurs inductifs répartis régulièrement sur un arc de cercle en regard des ajours, les dimensions et les espacements angulaires des ajours et des détecteurs étant tels qu'il existe toujours un détecteur en regard d'un ajour quelle que soit la position angulaire du disque par rapport à l'ensemble de détection ;
- l'organe rotatif est un essieu de bogie de véhicule ferroviaire.

L'invention a encore pour objet un procédé de contrôle du dispositif de mesure défini ci-dessus, caractérisé en ce que l'on modifie suivant une séquence de référence l'état de la spire ou de la bobine du détecteur en fonctionnement et l'on compare cette séquence de référence avec le signal de sortie de ce détecteur.

L'invention a encore pour objet un procédé de contrôle du dispositif de mesure défini ci-dessus, caractérisé en ce que, le disque étant immobile par rapport à l'ensemble de détection , on modifie suivant une séquence de référence l'état des moyens de contrôle d'au moins un détecteur en fonctionnement et en regard d'un ajour et l'on compare cette séquence de référence avec le signal de sortie de ce détecteur en regard d'un ajour .

L'invention sera mieux comprise à la lecture de la description qui va suivre donnée uniquement à titre d'exemple et faite en se référant aux dessins dans lesquels :
- la figure 1 est une vue schématique d'un bogie de véhicule ferroviaire portant un ensemble de détection selon l'invention ;
- la figure 2 est une vue en coupe, à échelle agrandie, suivant la ligne 2-2 de la figure 1 ;
- la figure 3 est une vue du disque du dispositif de mesure, suivant la flèche 3 de la figure 4, avec des coupes partielles ;
- la figure 4 est une vue suivant la flèche 4 de la figure 3 ;
- la figure 5 est une vue similaire à la figure 2 dans laquelle un outil de guidage est agencé en lieu et place du disque ;
- la figure 6 est une vue en coupe suivant la ligne 6-6 de la figure 5 ;
- la figure 7 est une vue schématique de l'ensemble de détection porté par le bogie ;
- les figures 8 et 9 sont des vues schématiques d'une spire de contrôle d'un détecteur de l'ensemble représenté à la figure 7 reliée à des moyens de modification de son état, respectivement, par mise en court-circuit et alimentation en courant ;
- la figure 10 est une vue similaire à la figure 2 montrant une variante de réalisation de moyens de centrage du disque par rapport à un essieu du bogie.

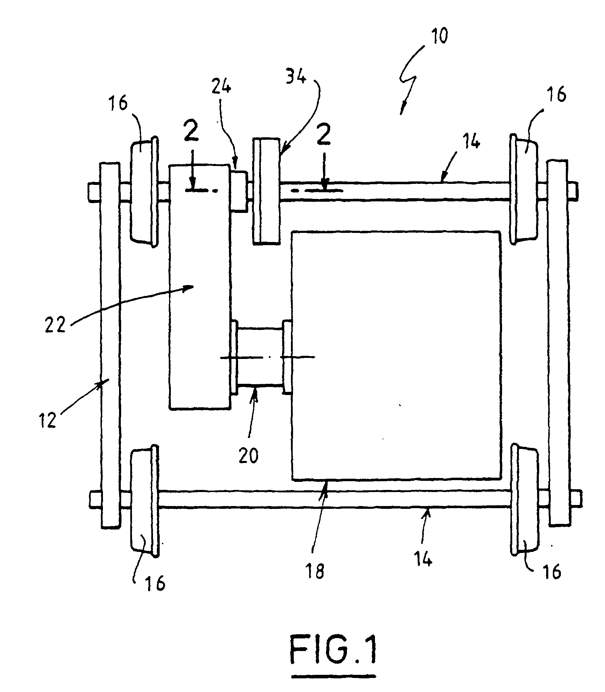

On a représenté schématiquement sur la figure 1 un bogie de véhicule ferroviaire désigné par la référence générale 10.

De façon classique, ce bogie comporte un châssis fixe 12 et une paire d'essieux 14, portant des roues 16, montés rotatifs sur ce châssis 12. Le bogie 10 comporte également un moteur électrique d'entraînement classique 18 relié à un essieu 14 par l'intermédiaire de dispositifs de couplage 20 et de réduction 22. Le bogie 10 comporte encore un ensemble classique 24 de retour de courant d'alimentation du moteur 18. Cet ensemble 24 assure le renvoi du courant provenant du moteur 18 vers l'essieu 14 couplé au dispositif de réduction 22, ceci à l'aide de moyens classiques de contact électrique par frottement.

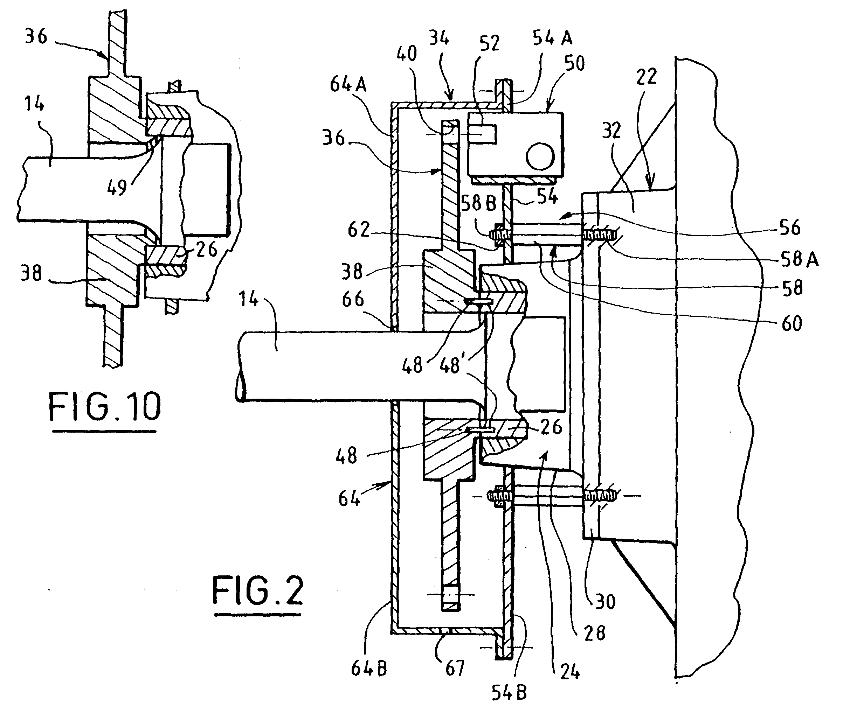

En se référant à la figure 2, on voit que l'ensemble de retour de courant 24 comporte une bague collectrice 26 formant un épaulement solidaire de l'essieu 14. L'ensemble de retour de courant 24 comporte également un boîtier fixe 28, entourant la bague collectrice 26, muni d'un flasque de fixation 30. Ce flasque 30 est fixé par des moyens qui seront décrits ultérieurement à un boîtier fixe 32 du dispositif de réduction 22 porté par le châssis 12.

Le bogie 10 comporte de plus un dispositif 34 de mesure d'une grandeur physique liée à la rotation de l'essieu 14 représenté en détail sur les figures 2 à 4. Ce dispositif de mesure 34 comporte un disque métallique 36 solidaire de l'essieu 14 et coaxial à ce dernier.

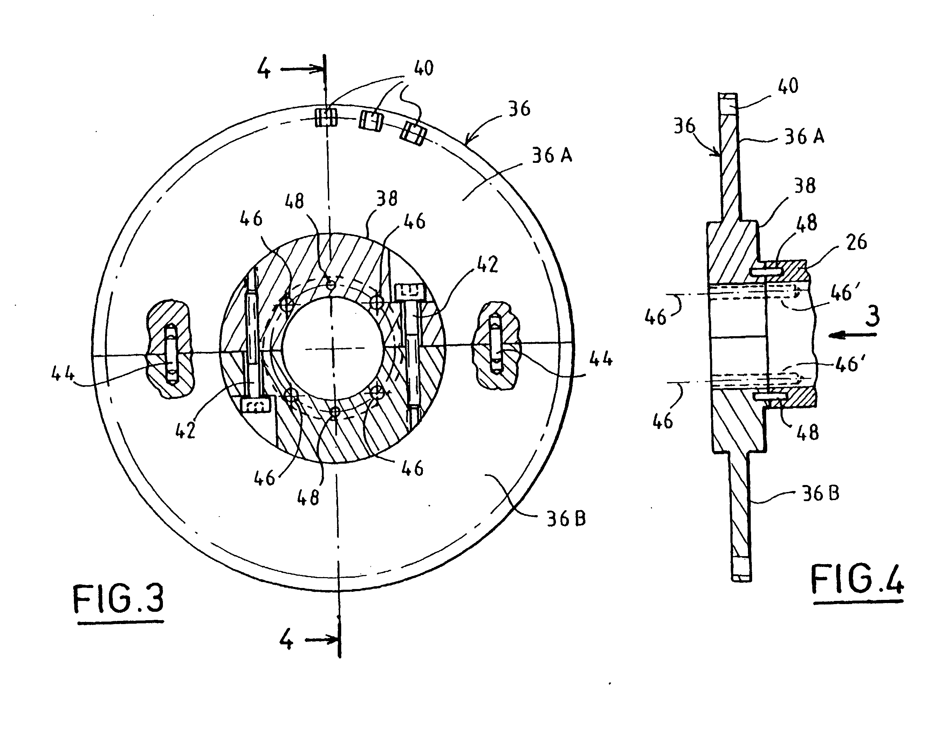

Le disque 36 comporte un moyeu 38 et au moins un ajour 40 formant repère. De préférence, le disque 36 comporte n ajours 40 répartis régulièrement sur un cercle centré sur son axe, n étant un entier non nul. Pour des raisons de simplification seulement trois ajours 40 sont représentés sur la figure 3.

Les ajours 40 sont formés, par exemple, par des orifices traversant l'épaisseur du disque, comme cela est représenté notamment sur les figures 2 et 3, ou par des encoches débouchant à la périphérie de ce disque.

Afin de permettre son montage autour de l'essieu 14, le disque 36 comporte au moins deux parties 36A,36B formant deux secteurs s'étendant chacun de préférence sur environ 180°, reliées entre elles par une paire de vis 42 et une paire de pions de centrage 44 sensiblement parallèles aux faces du disque 36 (voir figure 3).

Le moyeu 38 du disque est fixé sur une face libre de la bague collectrice 26 au moyen de vis 46 (schématisées par des traits interrompus sur la figure 4) et de pions de centrage 48 sensiblement perpendiculaires aux faces du disque 36 et parallèles à l'axe de l'essieu 14 (voir notamment figures 3 et 4).

Dans l'exemple illustré sur les figures, le moyeu 38 du disque est fixé sur la bague collectrice 26 au moyen de quatre vis 46 et de deux pions de centrage 48, à savoir deux vis 46 et un pion de centrage 48 par partie 36A,36B du disque.

En variante, les pions de centrage 48 peuvent être remplacés par d'autres moyens de centrage par rapport à l'essieu 14, par exemple un épaulement 49 usiné dans le moyeu 38 du disque coopérant avec le contour intérieur de la bague collectrice 26, comme cela est représenté sur la figure 10.

Le dispositif de mesure 34 comporte de plus un ensemble fixe 50 de détection des ajours 40 du disque 36.

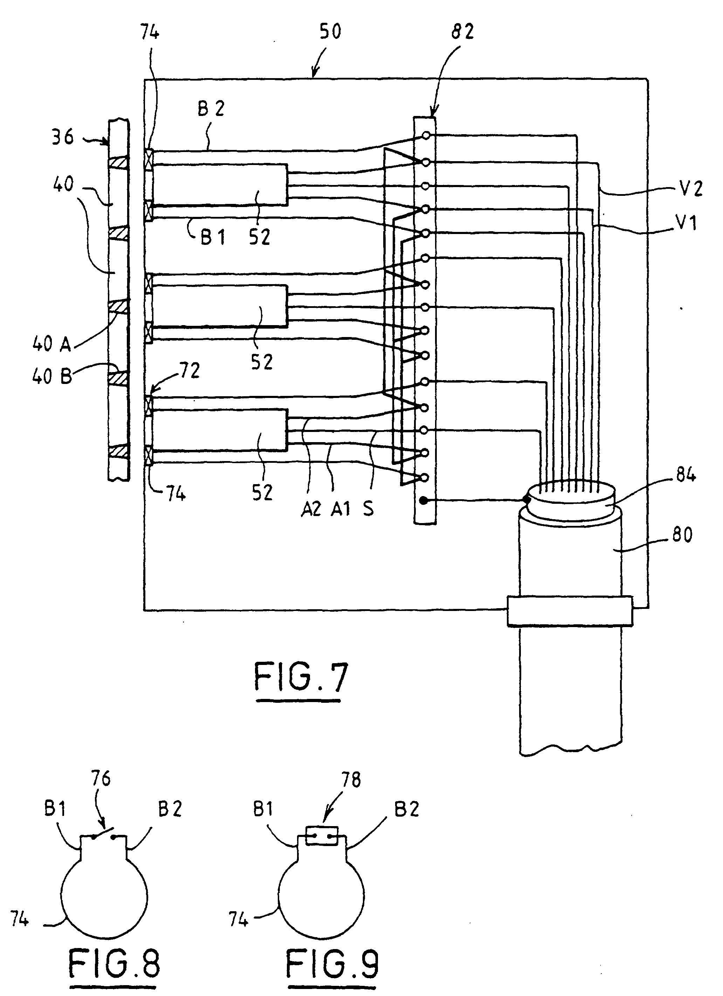

Cet ensemble de détection 50, représenté plus en détail sur la figure 7, comprend au moins un détecteur magnétique de proximité 52, par exemple trois comme illustré ou p, p étant un entier non nul, répartis régulièrement sur un arc de cercle en regard des ajours 40.

Les détecteurs 52 sont de type connu, par exemple de type inductif commercialisé par la société OMROM ELECTRONICS sous la référence E2EG. Ces détecteurs inductifs fonctionnent en utilisant le principe des courants de Foucault.

Les dimensions et les espacements angulaires des ajours 40 et des détecteurs 52 sont tels qu'il existe toujours un détecteur 52 en regard d'un ajour 40 quelle que soit la position angulaire du disque par rapport à l'ensemble de détection 50.

De préférence, afin d'empêcher l'accumulation de poussière dans les ajours 40, ces derniers sont délimités chacun par deux surfaces sensiblement radiales 40A,40B convergentes vers la face du disque 36 en regard de l'ensemble de détection 50, comme cela est représenté sur la figure 7.

L'ensemble de détection 50, qui sera décrit plus en détail ultérieurement, est porté par une platine fixe 54 (voir figure 2). Le flasque 30 du boîtier 28 de l'ensemble de retour de courant et la platine 54 sont reliés par au moins un organe de fixation commun 56, de préférence quatre, au boîtier 32 du dispositif de réduction. Ce boîtier 32 forme donc un support, porté par le châssis du bogie, commun au flasque 30 de l'ensemble de retour de courant et à la platine 54.

Chaque organe de fixation 56 comprend un goujon 58 muni de deux extrémités filetées 58A,58B et d'un corps polygonal de manoeuvre 60 espaçant le flasque 30 de la platine 54. Une première extrémité 58A du goujon, traversant le flasque 30 du boîtier 28, est vissée dans le boîtier 32 du dispositif de réduction. La seconde extrémité 58B du goujon, traversant la platine 54, est vissée dans un écrou de serrage 62.

Le disque 36 est recouvert par un capot de protection 64 relié, de façon connue en soi, à la platine 54.

Afin de permettre leur montage autour de l'essieu 14, la platine 54 et le capot 64 comprennent chacun au moins deux parties 54A,54B,64A,64B, formant deux secteurs s'étendant de préférence sur environ 180°.

On comprend donc que la platine 54 et le capot 64 forment un carter protégeant le disque 36 et l'ensemble de détection 50 contre les poussières et salissures environnantes ainsi que les projections d'eau sous le bogie.

Toutefois, on notera la présence d'un jeu radial 66 entre l'essieu rotatif 14 et la paroi du capot 64 traversée par cet essieu. Ce jeu radial 66 permet de tenir compte des tolérances de fabrication de l'essieu 14 et du capot 64.

Les poussières et salissures pénétrant le cas échéant, par le jeu 66, dans le carter formé par la platine 54 et le capot 64 ne sont pas susceptibles de perturber le bon fonctionnement des détecteurs inductifs de proximité 52 qui sont beaucoup moins sensibles aux poussières et salissures que les détecteurs optiques. Par ailleurs, l'eau susceptible de pénétrer dans le carter est évacuée naturellement par un trou 67 percé dans le bas du capot 64 (voir figure 2).

Le capot 64 assure donc une étanchéité suffisante pour garantir un bon fonctionnement des détecteurs inductifs de proximité 52. Il n'est donc pas nécessaire de recourir à des moyens d'étanchéité complexes et encombrants tels que ceux associés habituellement aux ensembles de détection optiques classiques.

On décrira ci-dessous un procédé d'usinage des moyens de fixation du disque 36 sur la face libre de la bague collectrice 26.

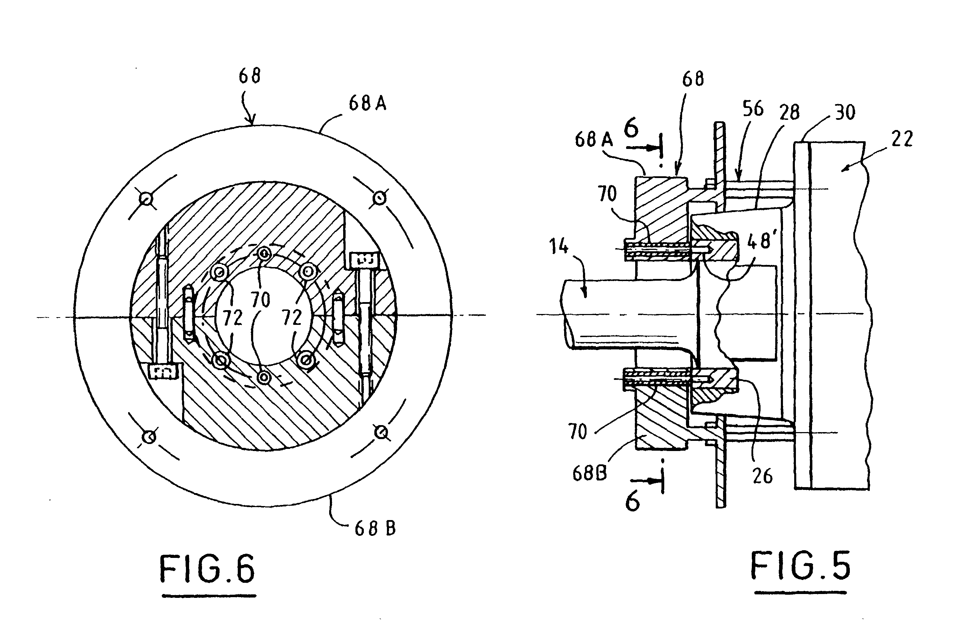

Tout d'abord, on fixe temporairement sur le boîtier 22 du dispositif de réduction un outil de guidage 68 de forme générale annulaire (voir figures 5 et 6), ceci au moyen des organes de fixation communs 56, en lieu et place de la platine 54.

Afin de permettre son montage autour de l'essieu 14, l'outil 68 comporte au moins deux parties 68A,68B formant deux secteurs s'étendant chacun de préférence sur environ 180°. Ces deux parties 68A,68B sont reliées entre elles par des moyens analogues à ceux reliant les deux parties 36A,36B du disque (voir figure 6).

L'outil de guidage 68 est centré par rapport à l'axe de l'essieu 14 à l'aide de moyens classiques.

Après avoir fixé et centré l'outil de guidage 68, on forme dans la face libre de la bague collectrice 26 des orifices de centrage 48' destinés à recevoir les pions de centrage 48 du disque (voir figure 2), et s'il n'en existe pas déjà, des orifices taraudés 46' destinés à recevoir les vis de fixation 46 du disque (voir figure 4), ceci au moyen d'un outil de perçage classique (non représenté) guidé par des canons de perçage 70,72 portés par l'outil de guidage 68.

Après avoir percé les orifices de centrage 48' et taraudés 46', on retire l'outil de guidage 68 et l'on fixe le disque 36 sur la face libre de la bague 26 avec les moyens décrits précédemment.

En variante, dans le cas où la face libre de la bague collectrice 26 comporte déjà des orifices taraudés, ces derniers forment alors les orifices 46' et l'outil d'usinage 68 peut être fixé temporairement sur la face libre de la bague au moyen de vis vissées dans ces orifices taraudés pré-existants, afin de pouvoir former les orifices de centrage 48'.

Il ressort donc de ce qui précède et plus particulièrement du procédé d'usinage décrit ci-dessus que le dispositif de mesure 34 peut être monté sur le bogie 10 sans démontage de ce dernier.

On décrira ci-dessous plus en détail l'ensemble de détection 50, en se référant aux figures 7 à 9.

On notera que les détecteurs 52 décrits sont de type inductif. Toutefois tout autre type de détecteur magnétique pourrait être utilisé dans le cadre de l'invention par exemple des détecteurs à effet Hall.

De façon classique, chaque détecteur inductif 52 est raccordé électriquement à deux conducteurs d'alimentation électrique A1,A2 et à un conducteur de signal de sortie S.

Chaque détecteur inductif 52 comporte des moyens 72 de contrôle de son bon fonctionnement. Ces moyens 72 sont agencés à l'extérieur du détecteur inductif, sans contact ou raccordement électrique avec ce dernier.

De préférence, les moyens de contrôle 72 comprennent au moins une spire conductrice 74 entourant une extrémité active du détecteur 52. Cette spire 74 est raccordée à des moyens de modification de son état. De tels moyens de modification d'état sont constitués, par exemple, par des moyens classiques de mise en court-circuit de la spire 74, comportant notamment un commutateur 76, comme cela est illustré sur la figure 8, ou bien par des moyens classiques 78 d'alimentation en courant de la spire 74, comme cela est illustré sur la figure 9.

En variante, la spire 74 peut être remplacée par une bobine conductrice constituée de plusieurs spires.

Chaque spire 74 est raccordée à des conducteurs d'entrée B1 et de sortie B2.

L'ensemble des conducteurs A1,A2,S,B1,B2 est raccordé à un câble multi-conducteurs 80 par l'intermédiaire d'un bornier 82.

On notera que les conducteurs d'alimentation A1,A2 des détecteurs 52 sont raccordés en parallèle entre eux et à deux conducteurs d'alimentation V1,V2 du câble 80. On notera également que les conducteurs d'entrée B1 des spires 74 sont raccordés à un point commun du bornier 82. On notera enfin que le câble 80 comporte un blindage 84 également raccordé au bornier 82.

De façon classique, chacun des détecteurs inductifs 52 comporte un oscillateur (non représenté) associé à un circuit électronique de détection. Le signal de sortie émis par le détecteur 52 est de type binaire (un niveau haut et un niveau bas). Le passage d'un élément métallique (portion de disque séparant deux ajours 40) devant le détecteur 52 modifie l'état de son oscillateur et provoque un changement de niveau du signal de sortie.

Lorsqu'un détecteur 52 est en fonctionnement et que son extrémité active est écartée de tout élément métallique perturbateur, la modification de l'état de la spire 74 associée à ce détecteur, par mise en court-circuit ou par alimentation en courant, provoque un changement de niveau du signal de sortie comme le ferait un élément métallique passant devant le détecteur 52.

Les moyens de contrôle 72 permettent donc de contrôler le dispositif de mesure 34 de la façon suivante.

Le disque 36 étant immobile par rapport à l'ensemble de détection 50, on modifie suivant une séquence de référence l'état de la spire 74 d'au moins un détecteur en fonctionnement et en regard d'un ajour 40. Il convient de rappeler que les dimensions et les espacements angulaires des ajours 40 et des détecteurs 52 sont tels qu'il existe toujours un détecteur en regard d'un ajour 40 quelle que soit la position angulaire du disque 36 par rapport à l'ensemble de détection 50.

La séquence de référence est comparée avec le signal de sortie du détecteur contrôlé de façon à vérifier que le niveau de ce signal change suivant une séquence identique à celle de référence. Dans le cas contraire, on peut conclure à un défaut de fonctionnement du détecteur 52 contrôlé.

On notera que le procédé décrit ci-dessus de contrôle d'un détecteur 52 permet de déceler tout déplacement accidentel du disque 36 par le fait qu'un tel déplacement engendre une disparité entre la séquence de référence et la séquence de changement de niveau du signal de sortie.

Tout déplacement accidentel d'un bogie et donc d'un véhicule ferroviaire pendant le procédé ci-dessus de contrôle d'un détecteur 52 peut donc être facilement détecté.

Les moyens de contrôle 72, indépendants du fonctionnement des détecteurs 52, permettent donc de réaliser un contrôle très fiable et sécuritaire de ces derniers.

## Revendications

1. Dispositif de mesure d'une grandeur physique liée à la rotation d'un organe (14) comprenant :
- un disque métallique (36), solidaire de l'organe rotatif (14), muni d'au moins un ajour (40) formant repère, et
- un ensemble fixe (50) de détection de ce repère comprenant au moins un détecteur magnétique de proximité (52), **caractérisé :**
- **en ce qu'**il comprend des moyens (72) de contrôle du bon fonctionnement de ce détecteur, agencés à l'extérieur du détecteur magnétique (52), sans contact ou raccordement électrique avec ce dernier, et
- **en ce que** le disque (36) comprend n ajours (40) répartis régulièrement sur un cercle centré sur son axe et l'ensemble de détection (50) comprend p détecteurs magnétiques répartis régulièrement sur un arc de cercle en regard des ajours (40), les dimensions et les espacements angulaires des ajours (40) et des détecteurs (52) étant tels qu'il existe toujours un détecteur (52) en regard d'un ajour (40) quelle que soit la position angulaire du disque (36) par rapport à l'ensemble de détection (50).

2. Dispositif selon la revendication 1, **caractérisé en ce que** les moyens de contrôle (72) comprennent au moins une spire conductrice (74) entourant une extrémité active du détecteur (52), raccordée à des moyens (76 ;78) de modification de son état par mise en court-circuit ou par alimentation en courant de cette spire.

3. Dispositif selon la revendication 2, **caractérisé en ce que** les moyens de contrôle (72) comprennent une bobine conductrice constituée de plusieurs spires (74) entourant une extrémité active du détecteur (52), raccordée à des moyens (76 ;78) de modification de son état par mise en court-circuit ou par alimentation en courant de cette bobine.

4. Dispositif selon l'une quelconque des revendications précédentes, **caractérisé en ce que** le détecteur magnétique (52) est un détecteur inductif de proximité.

5. Dispositif selon l'une quelconque des revendications précédentes, **caractérisé en ce que** l'organe rotatif est un essieu (14) de bogie de véhicule ferroviaire.

6. Procédé de contrôle du dispositif de mesure selon la revendication 1, **caractérisé en ce que**, le disque (36) étant mobile par rapport à l'ensemble de détection (50), on modifie suivant une séquence de référence l'état des moyens (72) de contrôle d'au moins un détecteur (52) en fonctionnement et en regard d'un ajour (40) et l'on compare cette séquence de référence avec le signal de sortie de ce détecteur (52) en regard d'un ajour (40).

## Patentansprüche

1. Vorrichtung zum Messen einer physikalischen Größe, die mit der Drehung eines Bauelementes (14) verbunden ist, mit:
- einer Metallscheibe (36), die fest mit dem sich drehenden Bauelement (14) verbunden ist und mit wenigstens einem Durchbruch (40) versehen ist, der eine Markierung bildet, und
- einer festen Anordnung (50) zum Erfassen dieser Markierung, die wenigstens einen magnetischen Näherungsdetektor (52) umfasst, **dadurch gekennzeichnet, dass**
- sie Einrichtungen (72) zum Überwachen der guten Funktion des Detektors umfasst, die an der Außenseite des Magnetdetektors (52) ohne Kontakt oder elektrische Verbindung mit diesem vorgesehen sind, und
- die Scheibe (36) n Durchbrüche (40) umfasst, die regelmäßig auf einem Kreis verteilt sind, der um ihre Achse zentriert ist, und die Detektoranordnung (50) p Magnetdetektoren umfasst, die regelmäßig auf einem Kreisbogen den Durchbrüchen (40) gegenüber verteilt sind, wobei die Abmessungen und die winkelabstände der Durchbrüche (40) und der Detektoren (52) derart sind, dass immer ein Detektor (52) einem Durchbruch (40) gegenüberliegt, unabhängig davon, wie die Winkelposition der Scheibe (36) bezüglich der Detektoranordnung (50) ist.

2. Vorrichtung nach Anspruch 1, **dadurch gekennzeichnet, dass** die Überwachungseinrichtungen (72) wenigstens eine leitende Windung (74) umfassen, die ein aktives Ende des Detektors (52) umgibt und mit Einrichtungen (76; 78) zum Modifizieren ihres Zustandes durch Kurzschluss oder durch Stromversorgung dieser Windung verbunden ist.

3. Vorrichtung nach Anspruch 2, **dadurch gekennzeichnet, dass** die Überwachungseinrichtungen (72) eine leitende Spule umfassen, die aus mehreren Windungen (74) besteht, die ein aktives Ende des Detektors (52) umgeben und mit Einrichtungen (76; 78) zum Modifizieren ihres Zustandes über einen Kurzschluss oder über eine Stromversorgung dieser Spule verbunden sind.

4. Vorrichtung nach einem der vorhergehenden Ansprüche, **dadurch gekennzeichnet, dass** der Magnetdetektor (52) ein induktiver Näherungsdetektor ist.

5. Vorrichtung nach einem der vorhergehenden Ansprüche, **dadurch gekennzeichnet, dass** das sich drehende Organ eine Achse (40) des Fahrgestells eines Schienenfahrzeuges ist.

6. Verfahren zum Überwachen einer Messvorrichtung nach Anspruch 1, **dadurch gekennzeichnet, dass** man bei einer bezüglich der Detektoranordnung (50) beweglichen Schreibe (36) gemäß einer Bezugsabfolge den Zustand der Einrichtung (72) zum Überwachen wenigstens eines Detektors (52) modifiziert, der arbeitet und einem Durchbruch (40) gegenüberliegt, und diese Bezugsabfolge mit dem Ausgangssignal dieses Detektors (52) vergleicht, der einem Durchbruch (40) gegenüberliegt.

## Claims

1. A device for measuring a physical quantity relating to the rotation of a member (14) including:
- a metal disc (36) secured to the rotating member (14) and provided with at least one opening (40) forming a reference point, and
- a stationary unit (50) for detecting the said reference point, and including at least one magnetic proximity detector (52), **characterised:**
- **in that** it includes means (72) for checking that the said detector is in good working order, the said means being arranged outside the magnetic detector (52) without electrical contact or connection therewith, and
- **in that** the disc (36) includes n openings (40) uniformly distributed around a circle centred on its axis, and the detection unit (50) includes p magnetic detectors uniformly distributed around an arc of a circle opposite the openings (40), the dimensions and angular separation of the openings (40) and detectors (52) being such that there is always a detector (52) opposite an opening (40) irrespective of the angular position of the disc (36) relative to the detection unit (50).

2. A device according to claim 1, **characterised in that** the checking means (72) include at least one conductive turn (74) which surrounds an active end of the detector (52) and is connected to means (76; 78) for modifying its state by short-circuiting the said turn or by supplying it with current.

3. A device according to claim 2, **characterised in that** the checking means (72) include a conductive coil which is made up of several turns (74) surrounding an active end of the detector (52) and which is connected to means (76; 78) for modifying its state by short-circuiting the said coil or by supplying it with current.

4. A device according to any one of the preceding claims, **characterised in that** the magnetic detector (52) is an inductive proximity detector.

5. A device according to any one of the preceding claims, **characterised in that** the rotary member is a railway vehicle bogie axle (14).

6. A method of checking the measurement device according to claim 1, **characterised in that**, the metal disc (36) being movable relative to the detection unit (50), the state of the means (72) for checking at least one detector (52) which is working and is opposite an opening (40) is modified according to a reference sequence and the said reference sequence is compared with the output signal of the said detector (52) opposite an opening (40).
